Europäisches Patentamt

European Patent Office

Office européen des brevets

(11) Publication number: **0 163 305**
**A2**

# (12) EUROPEAN PATENT APPLICATION

(21) Application number: **85106665.4**

(22) Date of filing: **30.05.85**

(51) Int. Cl.⁴: **G 06 F 13/38**

(30) Priority: **30.05.84 JP 108475/84**

(43) Date of publication of application:
**04.12.85 Bulletin 85/49**

(84) Designated Contracting States:
**DE FR GB**

(71) Applicant: **Oki Electric Industry Company, Limited
7-12, Toranomon 1-chome Minato-ku
Tokyo 105(JP)**

(72) Inventor: **Yokouchi, Hiroshi
Oki Electr. Indus. Co.,Ltd 7-12, Toranomon 1-chome
Minato-ku Tokyo(JP)**

(72) Inventor: **Miyazaki, Kazuhiko
Oki Electr. Indus. Co.,Ltd 7-12, Toranomon 1-chome
Minato-ku Tokyo(JP)**

(74) Representative: **Betten, Jürgen, Dipl.-Ing. et al,
Patentanwälte Lieck & Betten Maximiliansplatz 10
D-8000 München 2(DE)**

(54) Cmos type input-output circuit.

(57) In a CMOS type input-output circuit having an input control circuit, an output control circuit, a buffer circuit, a CMOS output buffer circuit and an input buffer circuit, said input-output circuit being capable of bidirectional transmission of information between a data bus and an I/O port, improvements on the control circuit are embodied by selecting a gate circuit in the input control circuit corresponding to that in the output control circuit. The output control circuit is connected to the input control circuit and the CMOS output buffer circuit. The CMOS output buffer circuit is connected to the input control circuit and the I/O port. Upon inputting a signal to both control circuit, the output control circuit floats the CMOS output buffer circuit; the input control circuit outputs a level fixing signal regardless of a logic level of the I/O port.

EP 0 163 305 A2

./...

# Fig. 1

SPECIFICATION


CMOS TYPE INPUT-OUTPUT CIRCUIT


BACKGROUND OF THE INVENTION

1. Field of the invention:

This invention relates to a CMOS type input-output circuit, and more particularly to a CMOS type input-output circuit suitable for microprocessors.

2. Description of the prior Art:

CMOS type input-output circuits are used in CMOS microprocessors or CMOS microcomputers which consume extremely little electrical power. The CMOS type input-output circuit is capable of bidirectional transmission of information between an I/O port and an internal data bus in both ways.

The CMOS type input-output circuit, in general, has a CMOS output buffer circuit connected with the I/O port, a CMOS input buffer which receives signals from the I/O port and expands noise margins, and a circuit which receives signals from the CMOS input buffer and selects some of them and transfers selected signals to the internal data bus.

An example of a conventional input-output circuit including one or more CMOS output buffers is described in "MICRO-CONTROLLOR HANDBOOK (INTEL,1983 ed.,Page 10-1 and 10-2)".

With such conventional input-output circuits, however, it is impossible to have the I/O port floated. Accordingly, the logic level of an external circuit should be made to correspond with the output logic level from the I/O port, before these circuits are powered down. In power down mode, these CMOS type input-output circuits have been desired to electrically separate the internal data bus from the I/O port in order to avoid the effects of the external circuits.

In this case, however, this causes a problem to consume a high electrical power. If the I/O port is turned off or has high input impedance, the I/O port is floated and PMOS and NMOS in the CMOS input buffer are simultaneously turned on. Therefore these MOS circuits consume electrical power in spite of the power down mode.

In addition, the floating of the I/O port can be prevented if a pull-up or pull-down resistor is connected with the E/O port and the voltage of the input buffer is fixed at high or low level. But the resistor attached consumes electrical power.

SUMMARY OF THE INVENTION

The present invention has one object to provide a CMOS type input-output circuit which consumes very little electrical power in power down mode of a microprocessor.

It is another object to provide a CMOS type input-output circuit which requires no pull-up or pull-down resistors preventing an I/O port from floating.

The CMOS type input-output circuit according to the present invention is connected to a data bus, an I/O port and an external control circuit for supplying control signals. The CMOS type input-output circuit comprises a buffer circuit, an output control circuit, a CMOS output buffer circuit, an input control circuit and an input buffer circuit. The buffer circuit is connected to the data bus and the output control circuit. The output control circuit is connected to the buffer circuit, the external control circuit and the CMOS output buffer circuit. The

- 3 -                          C163305

CMOS buffer circuit is connected to the output control circuit andthe I/O port. The input control circuit is connected to the I/O port, the external control circuit and the input buffer circuit. The input buffer circuit is connected to the input control circuit and the data bus.

In data output mode, the output control circuit receives information from the buffer circuit which temporarily stores information on the data bus, and sends the information to the I/O port via the CMOS output buffer circuit.

In data input mode, the input control circuit receives the information from the I/O port and sends it to the data bus via the input buffer circuit.

In power down mode, the output control circuit and the input control circuit receive the control signals, and the output control circuit makes the CMOS output buffer circuit floated, and the input control circuit produces a level fixing output signal, which is "H" or "L" level, regardles of a logic level of the I/O port.

BRIEF DESCRIPTION OF THE DRAWINGS

Fig.1 is a block diagram of a CMOS type input-output circuit embodying the invention.

Fig.2 is a connection diagram of a plurality of a CMOS type input-output circuit.

Fig.3 is a waveform diagram to explain the operation in the output mode of the circuit of Fig.1.

Fig.4 is a waveform diagram to explain the operation in the input mode of the circuit of Fig.1.

Fig.5 is a waveform diagram to explain the operation in the power down mode of the circuit of Fig.1.

Fig.6 is a circuit diagram of the input buffer circuit shown in Fig.1.

Fig.7, and Fig.8 are circuit diagrams of the input control circuit shown in Fig.1.

## DESCRIPTION OF THE PREFERRED EMBODIMENT

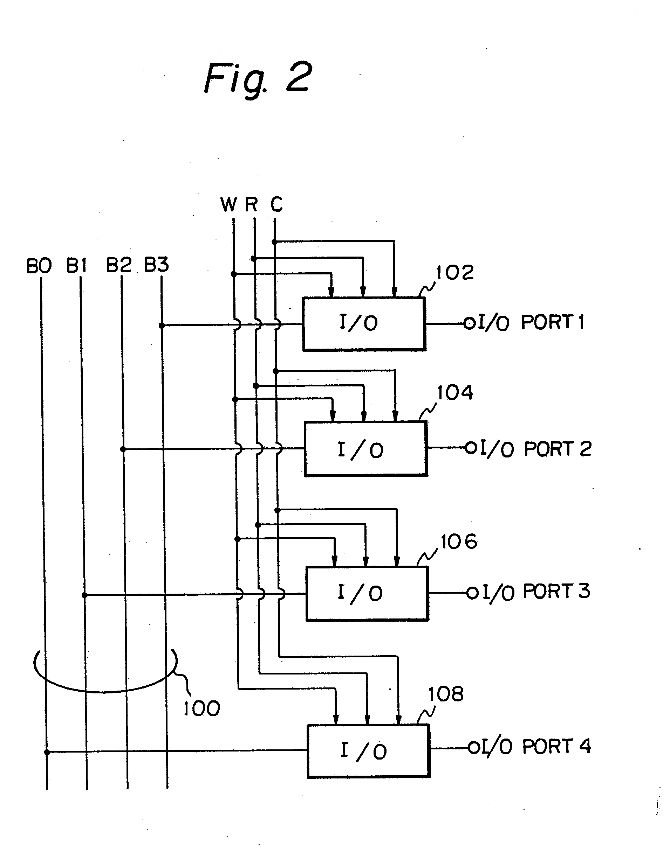

In Fig.2, each of one terminals of CMOS type input-output control circuits 102, 104, 106, 108 is respectively connected to bit lines B0, B1, B2, B3 of a data bus, and each of another terminals is respectively connected to I/O ports 1, 2, 3, 4. The CMOS circuits 102, 104, 106, 108 receive selectively "write" signal W,"read" signal R or "control" signal C. The write signal W causes the CMOS type input-output circuits 102, 104, 106, 108 to transmit information on the data bus 100 to the I/O port. The read signal R causes the CMOS type input-output circuits 102, 104, 106, 108 to transmit information on the I/O ports to the data bus 100. At power down mode of the microprocessor, the control signal C causes the I/O ports to float, and causes an output level of an internal control circuit to fix at "L" or "H". The internal control circuit does not turn on or off despite a fluctuation of the output level of the I/O ports. Accordingly, the CMOS type input-output circuits 102, 104, 106, 108 only consume very low electrical power.

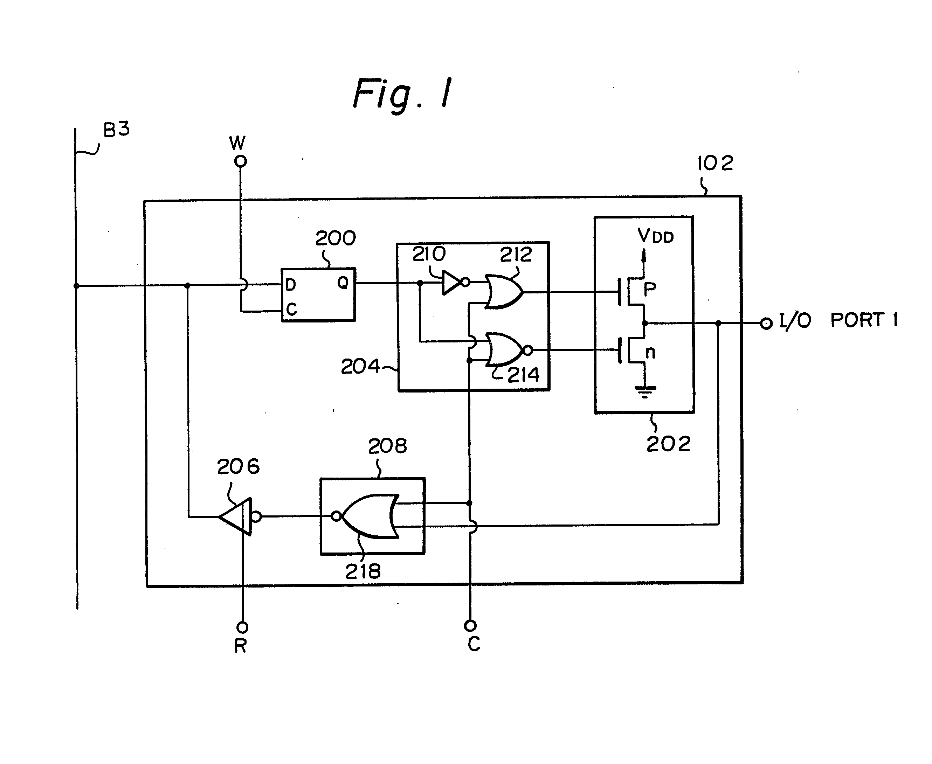

Fig.1 shows a preferred embodiment of such a CMOS type input-output circuit in accordance with the present invention. The CMOS type input-output circuit 102 comprises a latch circuit 200, a CMOS output buffer circuit 202, an output control circuit 204, an input buffer circuit 206, and an input control circuit 208. The latch circuit 200 temporarily stores a signal of the bit line B3 in the data bus 100 when receiving the write signal W.

The CMOS output buffer circuit 202 comprises PMOS and NMOS transistors, the output of which is connected to the I/O port 1. The output control circuit 204 transmits the output signal of the latch circuit 200 to the output buffer circuit 202 and turns off the PMOS and NMOS transistors when receiving by the control signal C. The input buffer circuit 206 transmits the signal of the I/O port 1 to the bit line B3 when receiving the read signal R. The input control circuit 208 transmits the signal of the I/O port 1 to the input buffer circuit 206 and disconnects electrically between the I/O port 1 and the input control circuit 206 when receiving the control signal C.

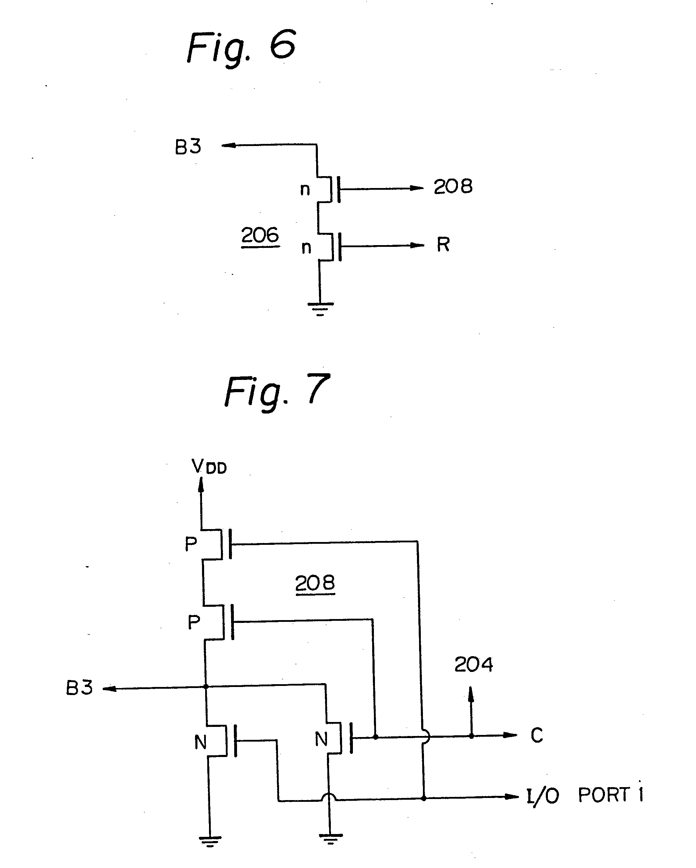

In detail,the latch circuit 200 is a data type flip-flop circuit, and the output control circuit 204 comprises, for example, a CMOS inverter 210, CMOS OR gate circuit 212 and CMOS NOR gate circuit 214. Fig.6 and Fig.7 show detailed circuit diagrams of the input circuit 206 and 208. The input buffer circuit 206 consists of two NMOS transistors connected in series show in Fig.6. The input control circuit 208, for example, consists of a NMOS gate circuit 208 and is constructed with a CMOS circuit shown in Fig.7.

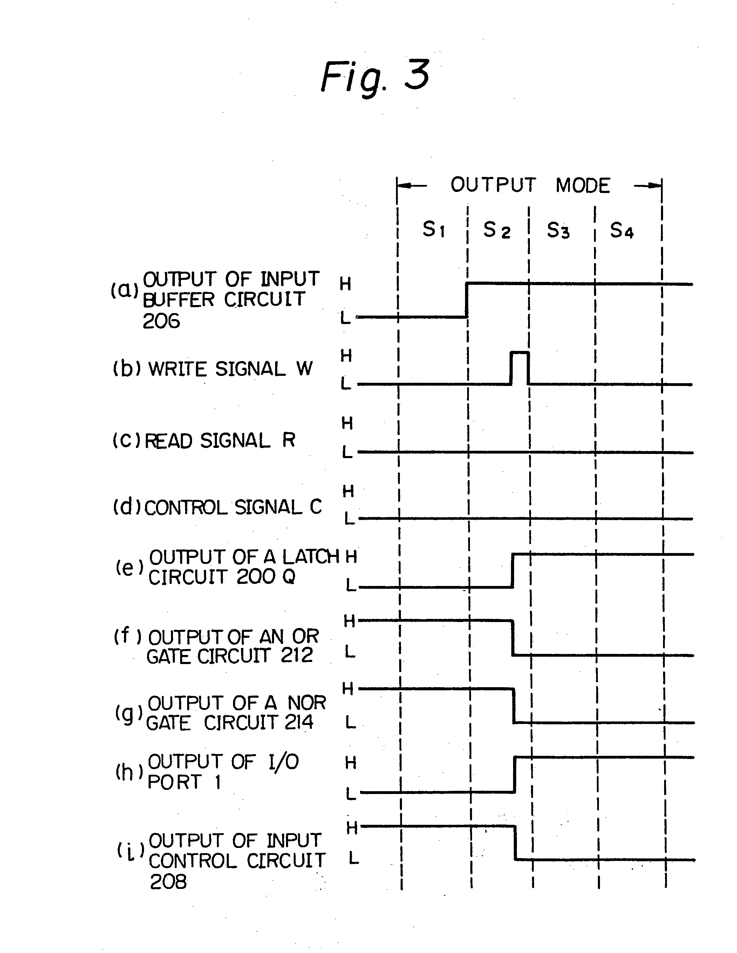

In following ,the operation of the CMOS type input-output circuit 102 in accordance with the invention will be described with references to the timing charts shown in Fig.3 to Fig.5:

(1) Data Output Mode

Referring to Fig.3, the data output mode is described of transmitting a data of the bit line B3 the data bus 100 to the I/O port 1. During a period of state S1, all logic levels of the bit line B3, the write signal W, the read signal R, control signal C and the I/O port 1 are assumed to be "L". During the period of state S2, the logic level of the bit line B3 turns to "H" level. When the latch circuit 200 receives the write signal W for transmitting the "H" level signal of the bit line B3 to the I/O port 1, the latch circuit 200 holds the "H" level signal of the bit line B3 and outputs a "H" level signal to the output control circuit 204. At the same time, because of the control signal C being holded as "L" level, the output control circuit 204 supplies "L" level signal to each of the PMOS and NMOS transistors of the output buffer circuit 202. Since the output signal of the output buffer circuit 202 turns to "H" level, "H" level signal of the bit line B3 is transmitted to the I/O port 1.

(2) Data Input Mode

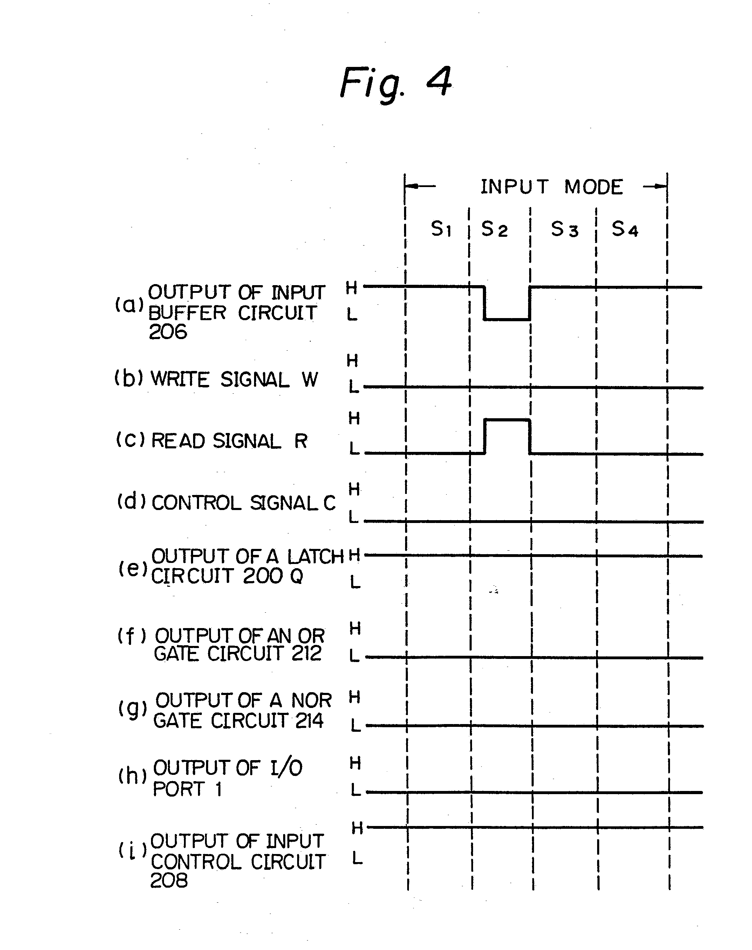

Referring to Fig.4, the data input mode is describedof transmitting a data of the I/O port 1 to the bit line B3. During the period of the state S1, all logic levels of the I/O port 1, the write signal W, the read signal R and the control signal C are assumed to be "L" level : the logic level of the bit line B3 and the input buffer circuit 206 are assumed to be "H" level. Because of the control signal C being "L" level, the input control circuit 208 outputs an "H" level signal which inverts the "L" level signal being applied to the I/O port to "H" level. During the period of state S2, when the "H" level read signal R is inputted the input buffer circuit 206 outputs a "L" level signal to the bit line B3. The "L" level signal may be stored, in for example, a memory in the microprocessor. Accordingly, when the "L" level read signal R is inputted during the period of state S3 the bit line B3 becomes "H" level.

(3) Power Down Mode

- 7 -

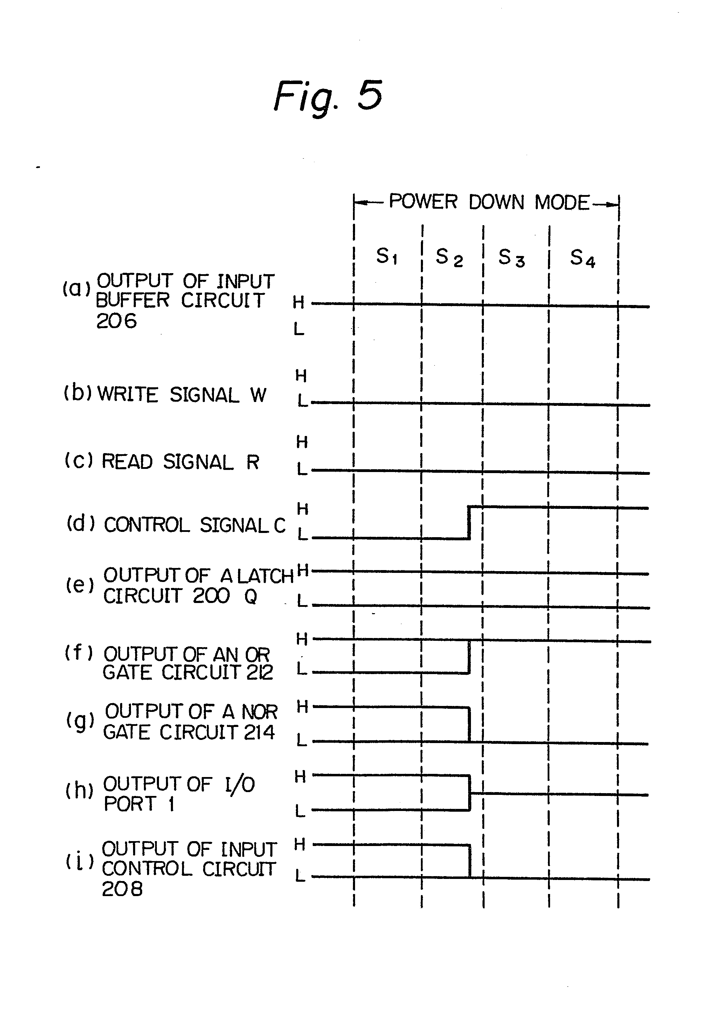

Referring to Fig.5, the operation of the CMOS type input-output circuit 102 in power down mode is described. During the period of state S1, the write signal W, the read signal R and control signal C are all assumed to be "L" logic level; the logic level of the bit line B3 is assumed to be "H" level and the logic level of the I/O port 1 is assumed to be "H" or "L" level. During the period of state S2, the "H" level control signal C is transmitted from a register(not shown) in microprocessoror a microcomputer to the output control circuit 204 and the input control circuit 208. Then, the OR gate 212 and the NOR gate 214 in the output control circuit 204 outputs "H" and "L" level signals respectively to the PMOS and the NMOS transistors, gate in the output buffer circuit 202 regardless of the logic level of the latch circuit 200. Since both PMOS and NMOS transistors in the output buffer circuit 202 turn off, the I/O port 1 becomes floating. Whereas, the output signal of the input control circuit 208 becomes "L" level regardless of output level of the I/O port 1. The input control circuit 208 can be constructed as is a CMOS NOR gate as shown in Fig.7 for example. Either of the PMOS transistors connected in series is fixed to be a cut-off mode, so that a power supply terminal Vdd in the input control circuit 208 is not grounded regardless of the voltage deviation of I/O port 1.

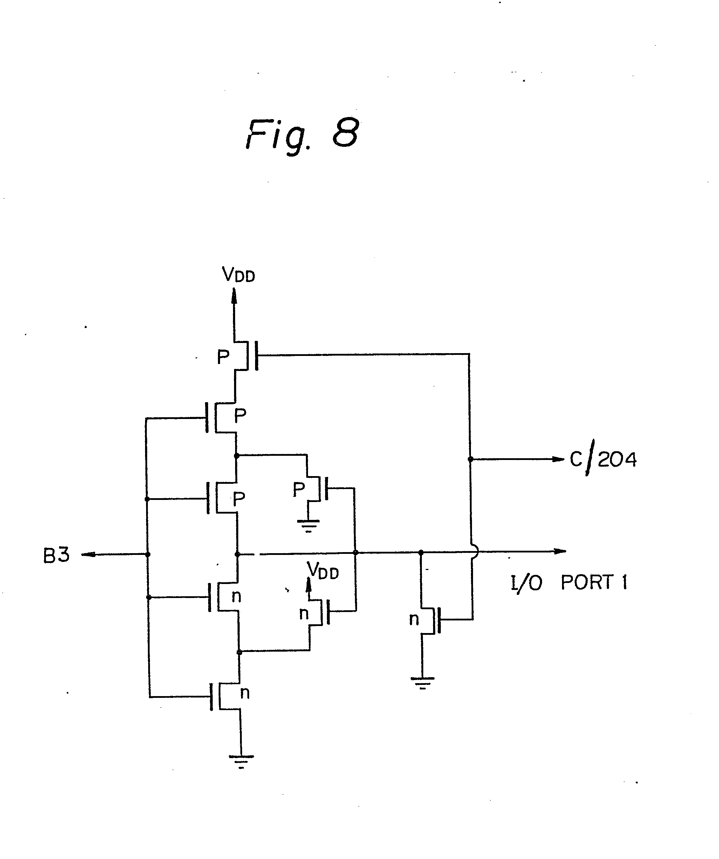

The use of a CMOS NOR gate as shown in FIG.8 having a hysteresis characteristic as the input control circuit 208, provides high noise margins, so that more stable characteristic against fluctuation of the logic level of the I/O port in normal operation mode can be obtained.

What is claim is:

1. A CMOS type input-output circuit connected to a data bus and an I/O port and an external control circuit supplying control signals, said input-output circuit being capable of bidirectional transmission of information between said data bus and said I/O port, which comprises:

a buffer circuit connected to said data bus, for temporarily storing information on said data bus;

an output control circuit connected to said buffer circuit and said external control circuit for receiving receives said information from said buffer circuit and transforming control signals in response to control signals arriving from said external control circuit;

a CMOS output buffer circuit connected to said output control circuit and said I/O port for transmitting said information from said output control circuit to said I/O port; said buffer circuit being capable of being floated by said transformed control signals;

an input control circuit connected to said I/O port and said external control circuit for and receiving information on said I/O port and said control signals to produce level fixed signals; and

an input buffer circuit connected to said input control circuit and said data bus for and transmitting information from said input control circuit to said data bus, whereby said control signal for floating said CMOS output buffer circuit is sent to said output control circuit and to said input control circuit, and said output control circuit makes said CMOS output buffer circuit float and said input control circuit produces said level fixed signal regardless of the logic level of said I/O port in response of said control signal response to said control signal.

2. A circuit of claim 1 wherein said CMOS output buffer circuit comprises a PMOS transistor and an NMOS transistor connected in series between a supply voltage and an earth.

3. A circuit of claim 1 wherein said output control circuit comprises an OR gate circuit having one inverted input to receive said control signals from said external control circuit for supplying information to said PMOS transistor's gate, and a NOR gate circuit having two inputs to receive information from said buffer circuit and to receive said control signals from said external control circuit for supplying information to said NMOS transistor's gate.

4. A circuit of claim 1 wherein circuit said input control circuitcomprises an OR gate circuit having two inputs to receive information on said I/O port and to receive said control signals for supplying information to said input buffer.

5. A circuit of claim 1 wherein said output control circuit comprises an AND gate circuit having one inverted input to receive information from said buffer circuit and another input to receive said control signals from said external control circuit for supplying information to said NMOS transistor's gate, and a NAND gate circuit having two inputs to receive information from said buffer circuit and to receive said control signals from said external control circuit for supplying information to said PMOS transistor's gate.

6. A circuit of claim 1 wherein said input control circuit comprises an AND gate circuit having two inputs to receive information on said I/O port and to receive said control signals for supplying information to said input buffer.

Fig. I

# Fig. 2

0163305

# Fig. 3

|  | OUTPUT MODE | | | |
|---|---|---|---|---|
|  | $S_1$ | $S_2$ | $S_3$ | $S_4$ |

(a) OUTPUT OF INPUT BUFFER CIRCUIT 206

(b) WRITE SIGNAL W

(c) READ SIGNAL R

(d) CONTROL SIGNAL C

(e) OUTPUT OF A LATCH CIRCUIT 200 Q

(f) OUTPUT OF AN OR GATE CIRCUIT 212

(g) OUTPUT OF A NOR GATE CIRCUIT 214

(h) OUTPUT OF I/O PORT 1

(i) OUTPUT OF INPUT CONTROL CIRCUIT 208

0163305

# Fig. 4

| | | INPUT MODE | |
| --- | --- | --- | --- |
| | S₁ | S₂ | S₃ | S₄ |

(a) OUTPUT OF INPUT BUFFER CIRCUIT 206

(b) WRITE SIGNAL W

(c) READ SIGNAL R

(d) CONTROL SIGNAL C

(e) OUTPUT OF A LATCH CIRCUIT 200 Q

(f) OUTPUT OF AN OR GATE CIRCUIT 212

(g) OUTPUT OF A NOR GATE CIRCUIT 214

(h) OUTPUT OF I/O PORT 1

(i) OUTPUT OF INPUT CONTROL CIRCUIT 208

# Fig. 5

POWER DOWN MODE

S₁  S₂  S₃  S₄

(a) OUTPUT OF INPUT BUFFER CIRCUIT 206    H / L

(b) WRITE SIGNAL W    H / L

(c) READ SIGNAL R    H / L

(d) CONTROL SIGNAL C    H / L

(e) OUTPUT OF A LATCH CIRCUIT 200 Q    H / L

(f) OUTPUT OF AN OR GATE CIRCUIT 212    H / L

(g) OUTPUT OF A NOR GATE CIRCUIT 214    H / L

(h) OUTPUT OF I/O PORT 1    H / L

(i) OUTPUT OF INPUT CONTROL CIRCUIT 208    H / L

## Fig. 6

B3 ← ... n 208 ... R
206

## Fig. 7

$V_{DD}$

P
208
P
B3 ←
N     N     C
I/O PORT i
204

# Fig. 8